(19) **Europäisches Patentamt / European Patent Office / Office européen des brevets**

(11) **EP 2 101 415 B1**

(12) **EUROPEAN PATENT SPECIFICATION**

(45) Date of publication and mention
of the grant of the patent:
**16.10.2013 Bulletin 2013/42**

(21) Application number: **08715188.2**

(22) Date of filing: **10.03.2008**

(51) Int Cl.:
**H03M 13/03** (2006.01)   **H04L 1/00** (2006.01)

(86) International application number:
**PCT/CN2008/070452**

(87) International publication number:
**WO 2008/110107 (18.09.2008 Gazette 2008/38)**

(54) **DATA ENCODING/DECODING AND RECEIVING/SENDING METHOD AND APPARATUS**

VERFAHREN UND VORRICHTUNG ZUR KODIERUNG/DEKODIERUNG SOWIE ZUM EMPFANGEN
UND SENDEN VON DATEN

PROCÉDÉ ET APPAREIL DE CODAGE/DÉCODAGE ET DE RÉCEPTION/ENVOI DE DONNÉES

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **12.03.2007 CN 200710088080**

(43) Date of publication of application:
**16.09.2009 Bulletin 2009/38**

(73) Proprietor: **Huawei Technologies Co., Ltd.
Longgang District, Shenzhen
Guangdong 518129 (CN)**

(72) Inventors:
• **LEUNG, Raymond W. K.
Shenzhen
Guangdong 518129 (CN)**

• **FENG, Dongning
Shenzhen
Guangdong 518129 (CN)**
• **GENG, Dongyu
Shenzhen
Guangdong 518129 (CN)**

(74) Representative: **Kreuz, Georg Maria et al
Huawei Technologies Duesseldorf GmbH
Dessauerstrasse 3
80992 München (DE)**

(56) References cited:
**CN-A- 1 625 859       CN-A- 1 860 713
US-A1- 2005 028 066    US-A1- 2006 098 686**

**Description**

FIELD OF THE TECHNOLOGY

The present invention relates to the communication field, and particularly to a communication technology of Forward Error Correction (FEC) encoding and decoding.

BACKGROUND

With the development of communication technologies, users impose higher and higher Quality of Service (QoS) requirements such as capacity and speed of communication. The access network is one of the most technically challenging areas in the whole telecom network. Therefore, in order to fulfill the user's increasingly higher requirements on bandwidth and implement high speed, broadband and intelligence of the access network, various access technologies are emerging, for example, Local Area Network (LAN), Digital Subscriber Line (DSL), Hybrid Fiber Coaxial Cable (HFC) network - cable modem, and Internet access through a power line. The most promising access technology is the optical access technology. A Passive Optical Network (PON) is a trendsetter in the optical access technologies by virtue of easy maintenance, high bandwidth, and low costs. The PON is a desirable physical platform for accessing multiple services such as voice, data, and video through a single platform.

The PON technology is a point-to-multipoint fiber access technology. The PON includes Optical Line Terminals (OLTs), Optical Network Units (ONUs), and an Optical Distribution Network (ODN). The Ethernet Passive Optical Network (EPON) technology is a desirable access technology. The EPON is characterized by easy maintenance, cost-efficiency, high transmission bandwidth, and a high performance-to-price ratio. Especially, the EPON technology provides bandwidth of 1 GHz and even 10 GHz, thus making it possible to transmit voice, data and video services concurrently. This feature of the EPON is never available from other access modes such as Digital Subscriber Line (DSL) and HFC-Cable Modem.

Because the EPON is a technology that adopts passive optical transmission, it does not use any amplifying or relaying component. Therefore, the transmission distance and the quantity of branches of an EPON network depend on the power budget and various transmission losses. With the increase of the transmission distance or the branches, the Signal-to-Noise Ratio (SNR) of transmitting data diminishes, thus leading to more bit errors. In order to solve such a problem, a FEC technology is introduced into the EPON system to improve the anti-interference capability of the system and increase the power budget of the system.

The basic principles of the FEC in an EPON system are: check data of FEC codewords are appended to the Ethernet frame transmitted from the sender; such check data and the encoded Ethernet frame data are interrelated (constrained) according to certain rules; the receiver checks the relation between the Ethernet frame data and the check data according to the established rules. Once an error occurs in the transmission, such relation is disrupted, and the erroneous codes are discovered and corrected automatically. The FEC technology attempts to use the least check bytes to correct the most errors, and finds out the best tradeoff between the overhead (more check bytes) and the obtained encoding gain.

In an EPON system, in order to make the transmitted data in a format receivable by the receiver, a line encoding technology needs to be applied before the FEC technology is applied. The line encoding needs to ensure the transmitted data to have enough transition (namely, transit between 0 and 1). In this way, the receiver can recover the clock. The line encoder also provides a method for aligning data with words, and the line keeps good direct current balance at the same time.

The line encoding mechanism comes in two types: value matching mechanism and scrambler mechanism. In an existing EPON system, an 8b/10b (namely, 8 bits/10 bits) line encoding mechanism is applied. It is a value matching mechanism. A noticeable defect of the 8b/10b encoding scheme is that its encoding redundancy reaches 25% and its encoding overhead is very high. In order to save encoding overhead, the 64b/66b line encoding is already applied in the Physical Encoding Sublayer (PCS) in the 10GBASE-W and 10GBASE-R standards. In the 10GBASE-T standard, the 64b/65b line encoding is applied in the PCS. Moreover, in 10GEPON system under development by the IEEE802.3av workgroup, a line encoding mechanism with higher encoding efficiency such as 64b/66b and 64b/65b is also introduced tentatively. In the two line encoding modes mentioned above, a scrambling mode with a non-scrambling synchronization character and a control character is applied.

The 64b/66b encoding mechanism adds a 2-bit synchronization character (sync header) on the basis of the 64-bit information. The 2-bit synchronization character is either "01" or "10". The synchronization character "01" means that all the 64 bits are data information. The synchronization character "10" means that the 64-bit information includes data information and control information. If the synchronization character is "00" or "11", it indicates that errors occur in the transmission process. Meanwhile, such a synchronization character ensures the transmission data to transit at an interval of at least 66 bits, thus facilitating the implementation of block synchronization. The 64-bit information is scrambled through a self-synchronizing scrambling mechanism, thus maximally ensuring the transmitted information to have enough transition and facilitating clock recovery of the receiver. The 64b/65b encoding mechanism differs from the 64b/66b encoding mechanism in that the 64b/65b encoding mechanism uses a 1-bit data character or control character. The data/control character "0" means that all the 64 bits are data information, and the data/control character "1" means that the 64-bit information includes data information and control information.

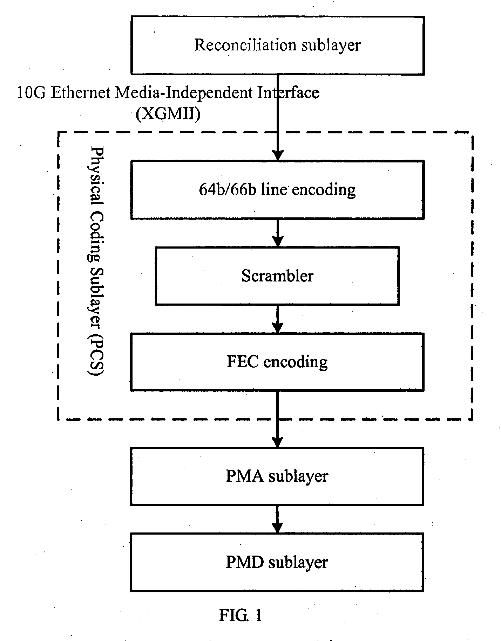

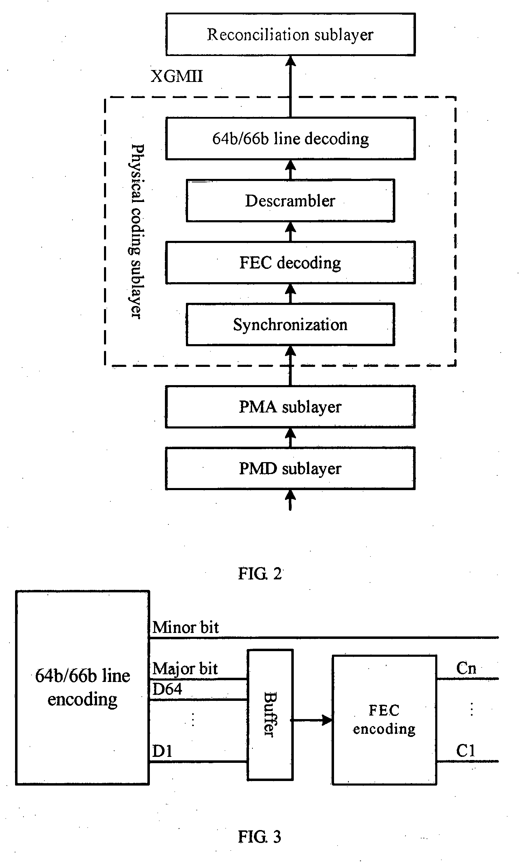

FIG. 1 and FIG. 2 show a design scheme for the PCS layer in a 10G EPON system in the prior art. FIG. 1 is a transmitting flowchart of the physical layer of the EPON system, and FIG. 2 is a receiving flowchart of the physical layer of the EPON system.

In FIG. 1, an Ethernet data frame is processed through a reconciliation sublayer and a 10G Ethernet Media-Independent Interface (XGMII) first, and then undergoes the 64b/66b line encoding. This encoding process is to add a 2-bit synchronization character before the 64-bit Ethernet data information so that the data changes from the original 64-bit data to 66-bit data. Generally, encoded 66-bit words are called a block. Subsequently, the data and control information in the block are scrambled and framed, and then the data in the frame is encoded through FEC encoding. The encoded data passes through the Physical Medium Attachment (PMA) sublayer and the Physical Medium Dependent (PMD) sublayer before being sent out. As shown in FIG. 2, the receiving process on the physical layer is an inverse process of the transmitting process, and is not repeated here any further.

In the process of implementing the foregoing solution, the inventor of the present invention finds that the benefits of line encoding and FEC encoding are accomplished at the cost of redundancy information increase. In the prior art, FEC encoding is performed for the data that has undergone line encoding. Consequently, the FEC treats the redundancy information of line encoding as the data of the FEC encoding and encodes the redundancy information of line encoding as well, thus reducing performance of the FEC encoding.

US 2006/098686 A1 discloses a frame transmitting apparatus that transmits a frame including data to be transmitted or a frame including control data for a data- transmission control via a network includes a frame generating unit that generates a frame including identification- information- added data to which 1- bit identification information indicating whether a block obtained by dividing data into every n bits includes the control data is added, where n is a positive integer, and an error control code for a data- transmission error control; and a frame transmitting unit that transmits the frame generated.

US 2005/028066 A1 discloses error correction on high speed interconnection links- backplane or extended wires (cable, optical fiber)- is exhaustively considered by many telecommunication vendors, especially those who offer "scalable router" products. Since the 64b/ 66b encoding scheme is a strong candidate of high speed interconnection protocol, error correction on 64b/ 66b encoded links is of interest. Although the IEEE 802.3 10G Ethernet standard does not specifically refer to packet loss, it can be shown that even only a single- bit error correction can significantly enhance the quality of the link. The present invention presents a simple and fast error- correction scheme that can be used in conjunction with the 64b/ 66b encoding in products where intra- board (chip- to- chip) or inter- shelf interconnections of high speed elements are required. It utilizes the CRC 16 to optimize on error detection, correction, or both: it detects and corrects all single- bit errors and detects all multiple- bit errors."

SUMMARY

The technical objective of the present invention is to provide a method and an apparatus for encoding, decoding, receiving and transmitting data to improve the encoding gain of the FEC encoding without increasing transmission overhead, as disclosed by the appended claims.

In the embodiments of the present invention, the minor bit(s) in block header of the information blocks are not involved in the FEC encoding. Therefore, fewer important information bits are protected by the same size of check blocks, and the FEC encoding obtains a higher encoding gain and reduces error probability of important information bits. Compared with the prior art, the technical solution under the present invention obtains a higher encoding gain without increasing the implementation complexity, and therefore, increases the power budget of the 10G EPON system.

BRIEF DESCRIPTION OF THE DRAWINGS

FIG. 1 is a data transmitting flowchart of a physical layer in a 10G EPON system in the prior art;

FIG. 2 is a data receiving flowchart of a physical layer in a 10G EPON system in the prior art;

FIG. 3 is a schematic view of a method for encoding and transmitting data according to the first embodiment of the present invention;

FIG. 4 is a flowchart of a method for encoding and transmitting data according to the first embodiment of the present invention;

FIG. 5 is a schematic view of operations on information blocks in a method for encoding and transmitting data according to the first embodiment of the present invention;

FIG. 6 is a flowchart of a method for receiving and decoding data according to the second embodiment of the present invention;

FIG. 7 is a schematic view of operations on information blocks in a method for receiving and decoding data according to the second embodiment of the present invention;

FIG. 8 is a schematic view of operations on information blocks in a method for encoding and transmitting data according to the third embodiment of the present invention;

FIG. 9 is a flowchart of a method for encoding and transmitting data according to the fifth embodiment of the present invention;

FIG. 10 is a schematic view of a method for encoding and transmitting data according to the sixth embodiment of the present invention;

FIG. 11 is a flowchart of a method for encoding and transmitting data according to the sixth embodiment of the present invention;

FIG. 12 is a schematic view of operations on information blocks in a method for encoding and transmitting data according to the sixth embodiment of the present invention;

FIG. 13 is a schematic structural view of an apparatus for encoding and transmitting data according to the seventh embodiment of the present invention;

FIG. 14 is a schematic structural view of an apparatus for encoding and transmitting data according to the eighth embodiment of the present invention;

FIG. 15 is a schematic structural view of an apparatus for encoding and transmitting data according to the ninth embodiment of the present invention;

FIG. 16 is a schematic structural view of an apparatus for encoding and transmitting data according to the tenth embodiment of the present invention; and

FIG. 17 is a schematic structural view of an apparatus for receiving and decoding data according to the eleventh embodiment of the present invention.

## DETAILED DESCRIPTION

In order to make the technical solution, objectives and merits of the present invention clearer, the embodiments of the present invention are described below in detail by reference to accompanying drawings.

The first embodiment of the present invention relates to a method for encoding and transmitting data. In this embodiment, an information block includes a block header which is a sync header. The sync header includes two bits for block synchronization. The information data in each information block includes 64 bits. The sender performs 64b/66b line encoding for the 64-bit information data first, and generates a 2-bit sync header. Of the two bits in the sync header, one is a major bit for synchronizing blocks and indicating the type of the information data in the information block, and the other is a minor bit. Afterward, the 64-bit information data and the major bit are sent into a buffer as input data bits of the FEC encoder. When the data bits in the buffer constitute a FEC encoding data frame, all such data bits are sent to the FEC encoder together for encoding. The minor bit in the sync header is not involved in the FEC encoding, as shown in FIG. 3.

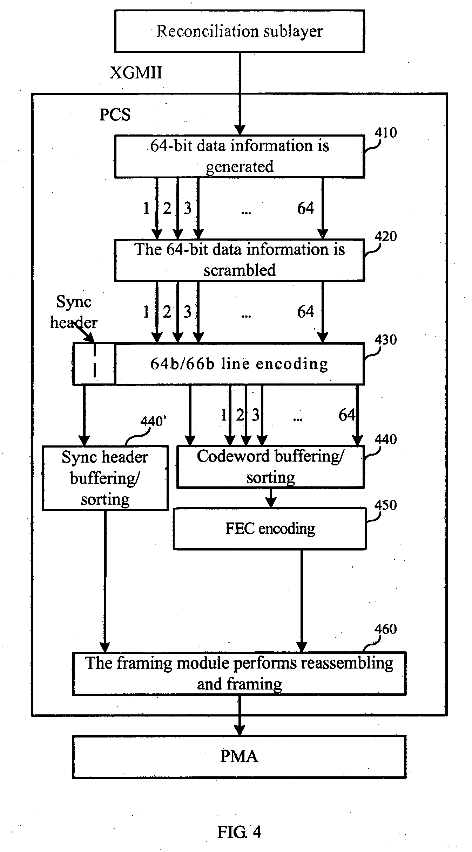

FIG. 4 shows a detailed process of this embodiment. In step 410, through an XGMII, the sender transmits the information data as an Ethernet packet from the reconciliation sublayer to a 64-bit information generating module. When the size of the data in the module reaches 64 bits, 64-bit information data is generated.

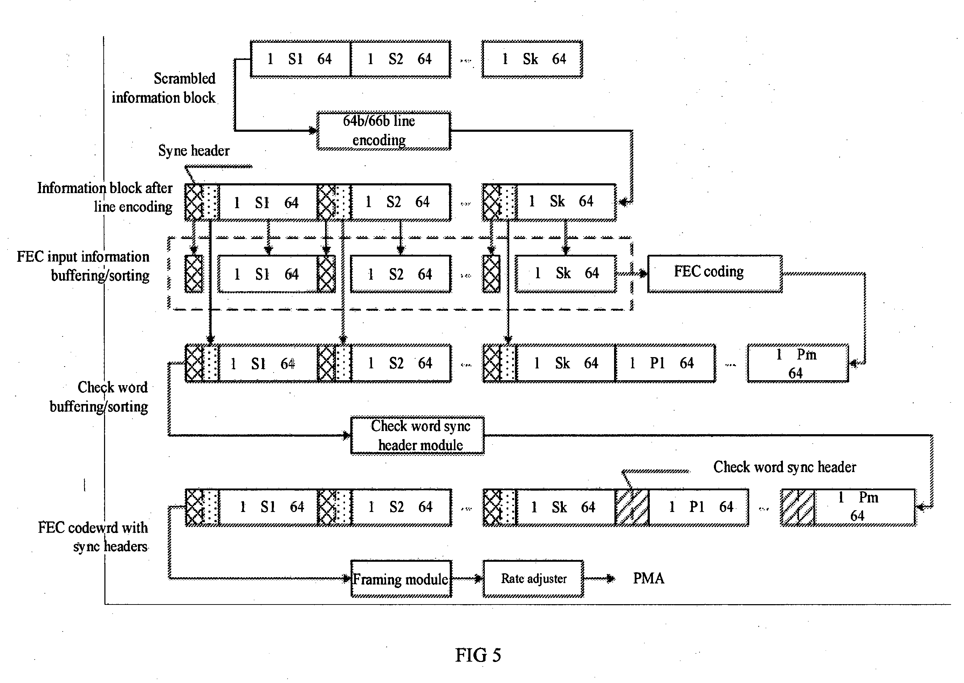

Subsequently in step 420, the sender scrambles the generated 64- bit information data, thus maximally ensuring the transmitted information data to have enough transition to facilitate clock recovery of the receiver. Specifically, when the data is transmitted from the XGMII to the 64- bit information module, the 64- bit information module divides the received data into K blocks, each block containing 64 bits. Afterward, each block is scrambled. The scrambled information data is shown in FIG. 5, where the information blocks are expressed as $S_i$ ($i = 0, 1, \cdots K$).

Subsequently in step 430, the sender performs 64b/66b line encoding for the scrambled information data. Specifically, the sender performs 64b/66b line encoding for each 64-bit information data. The process of line encoding is: adding a 2-bit sync header at the head (or end) of the information blocks $S_i$ as a block header. In the sync header, one bit (for example, the first bit) carries information that indicates the data type in the information blocks $S_i$, and therefore, this bit is a major bit; and the other bit (for example, the second bit) is a minor bit. The data comes in two types: pure data, and data with control information. For example, if the major bit is "0", it indicates that the information data in the information blocks $S_i$ is pure data; if the major bit is "1", it means that the information data in the information blocks $S_i$ carries control information, and vice versa. The minor bit in the sync header is a negation of the major bit. FIG. 5 shows the information blocks after line encoding.

The 64b/66b line encoding accomplishes three functions. The first function is to perform block synchronization through the 2-bit sync header in the 64b/66b encoding. The synchronization process is: In the data received at the receiver, the 64b/66b line encoding is applied, and therefore, synchronization bits "01" or "10" exist in every 66 bits. Such bit combinations also exist elsewhere within bit streams. First, the synchronization program selects a starting point randomly, and searches for valid synchronization bits ("01" or "10"). If no valid synchronization bits are found, the synchronization program shifts one bit, and then detects the synchronization bits again. Once a "01" or "10" combination is found, the synchronization program checks whether the 65th and the 66th bits after such a combination are the same combination (namely, "01" or "10" combination). If such is the case, the counter increases by 1, and the synchronization program keeps on detecting subsequent bits. If enough synchronization symbols are found continuously in one line without errors, the blocks are determined as aligned. If any error occurs in the detection process, the counter is reset. The second function is to ensure that the level of the transmitted data has enough transition to facilitate clock recovery at the receiver. The third function is to indicate the information type of the transmitted 64 bits through a sync header. For example, the sync header "01" means that all the transmitted 64 bits are data, and the sync header "10" means that the transmitted 64 bits include control information. This embodiment takes the 64b/66b line encoding as an example. In practice, 32b/34b line encoding is also applicable. Therefore, this embodiment is flexibly accomplishable.

Subsequently in step 440 and step 440', the sender buffers and sorts the information blocks Si. Specifically, the scrambled 64-bit information and the major bit of the sync header in the information blocks Si are transmitted to a codeword buffering/sorting module. The codeword buffering/sorting module buffers and sorts the received data, makes up a FEC encode frame, and transmits the minor bit in the sync header of the information blocks $S_i$ to a sync header buffering/sorting module for buffering and sorting. As shown in FIG. 5, the information blocks with a sync header is buffered and sorted. When the quantity of buffered bits reaches K information blocks (66*K bits), the scrambled information data (64*K bits) and the major bits (K bits) are transmitted to the codeword buffer/sorting module for buffering and sorting and making up a FEC encode frame, and the minor bits (K bits) are transmitted to the sync header buffering/sorting module for buffering and sorting. Therefore, the minor bits in the sync header are not involved in the FEC encoding. That is because: The third function of the 64b/66b encoding (identifying whether the information blocks are pure data or carry control information) can be performed through only one of the two bits of the sync header. The two bits in the sync header are always in a certain relation, for example, the exclusive-or (XOR) result of the two bits is 1. Therefore, the negation of one bit in the sync header is the other bit in the sync header. Therefore, a major bit in the sync header needs to be involved in the FEC encoding, and the other bit (the minor bit) does not need to be involved in the FEC encoding.

Subsequently in step 450, the sender performs FEC encoding for the compositional FEC encode frame. That is, the corresponding check word(s) is generated according to the compositional FEC encode frames. A constraint relation exists between the check word and the information. Such a constraint relation enhances the anti-interference capability of the information blocks. As shown in FIG. 5, the FEC encoding is performed, and the generated check blocks are $P_i$ (I = 0, 1, ... M). The check blocks are parity blocks of the FEC codeword.

Because only one major bit in the sync header is involved in the FEC encoding, a higher encoding gain is obtained with the same size (compared to the prior art) of check blocks. Because the major bit indicative of the data type is protected through FEC encoding, higher encoding gains improve the probability of determining the data type correctly.

It is worthy of attention that optionally, the check blocks may also be transmitted to a check word sync header module, and the check word sync header module adds 2-bit sync headers "Parity_header_1" and "Parity_header_2" to each check blocks Pi. The check word sync header is designed to distinguish the information data from the check word in the FEC codeword, namely, distinguish the blocks $S_i$ from the blocks $P_i$. In this embodiment, a 2-bit sync header is added to each check blocks.

Subsequently in step 460, after the FEC encoding is finished, the FEC codeword(s) is transmitted to a framing module. The framing module needs also to receive K minor bits buffered and sorted by the sync header buffering/sorting module. After being reassembled and framed, the bits are sent to the PMA in the form of frames for further transmission. As shown in FIG. 5, the information blocks $S_i$ with a sync header and the check blocks corresponding to the information blocks are reassembled and framed, and, after rate adjustment, transmitted to the PMA for further transmission.

Evidently, in this embodiment of the present invention, the minor bits in block header of the information blocks are not involved in the FEC encoding. Therefore, fewer important information bits are protected by the same size of check blocks, and the FEC encoding obtains a higher encoding gain and reduces error probability of important information bits. Compared with the prior art, this embodiment of the present invention obtains a higher encoding gain without increasing the implementation complexity, and therefore, increases the power budget of the EPON system.

Specifically, in the prior art, the FEC encoding is performed for the 66*K bits information, and the generated check word protects the 66*K bits information. In this embodiment, the FEC encoding is performed for the 65*K bits information, and the length of the generated check word is the same as that in the prior art., while the protection is performed for the information of the 65*K bits only (the bits that need to be protected are K bits fewer than that in the prior art) . Therefore, the check word protects the information bits more strongly, and the error rate of the information bits is lower. In addition, the receiver determines the data type of the 64- bit information in the 64b/ 66b encode block more accurately.

That is because, in the prior art, the data type of the line encode block of the receiver is determined only if the two bits of the sync header are "01" or "10"; if the two bits are "00" or "11", the data type cannot be determined. Therefore, the probability of correct judgment $P_{(correct)}$ is: $P_{(correct)} = (1- p_e) (1- p_e) = 1- 2p_e + p_e^2$, where $p_e$ is the error rate per bit in the prior art. In this embodiment, the receiver can determine the data type of the information by determining only the data type of the sync header involved in the FEC encoding. The probability of correct determination is: $P'_{(correct)} = 1 - p'_e$, where $p'_e$ is an error rate per bit in this embodiment. In this embodiment, the same amount of check words protect less information data, thus reducing the error rate of information bits, namely, $p'_e < p_e$. When $p_e$ ($p'_e$) is very small (in optical communication, $p_e$ ($p'_e$) is generally $10^{-12}$) :

$$P_{(correct)} = (1 - p_e)(1 - p_e) = 1 - 2p_e + p_e^2$$

$$\approx 1 - 2p_e < 1 - p'_e = p'_{(correct)}$$

Therefore, the receiver determines the data type of the 64- bit information in the 64b/ 66b encode block more accurately.

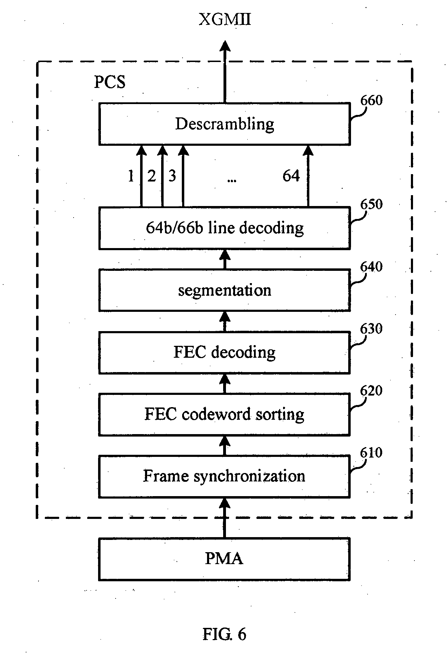

Corresponding to the method for transmitting and encoding data in the first embodiment, the second embodiment of the present invention relates to a method for receiving and decoding data. As shown in FIG. 6, the method includes the following steps:

Step 610: The PMA of the receiver performs frame synchronization for the information received from the PMD. The frame synchronization of the information is performed by using the 2-bit sync header "01" or "10" in the 64b/66b encode block. According to the result of frame synchronization, the information blocks with a sync header and the check blocks corresponding to this information blocks are obtained.

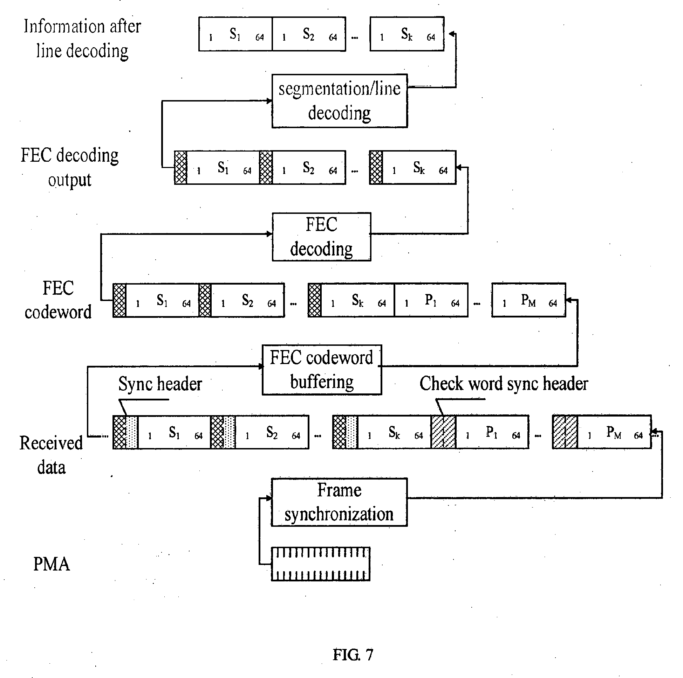

Step 620: The information are transmitted to a FEC codeword sorting module for sorting. Specifically, the FEC codeword sorting module removes the minor bit in the sync header of the information blocks according to rule that the sync header in the information blocks at the sender is involved in the encoding, and disassembles the information into a dataset that includes the major bits in the sync header, information data, and check blocks(s). This dataset is called a FEC codeword. The FEC codeword is sorted. As shown in FIG. 7, the information after frame synchronization includes: information blocks, check information corresponding to the information blocks, and a check word sync header. The information blocks $S_i$ is distinguished from the check blocks $P_i$ in the FEC codeword according to the information of the check word sync header. Meanwhile, the minor bit of the sync header in the information blocks $S_i$ and the check word sync header are removed. The remaining information is transmitted into a FEC codeword buffer for buffering and sorting.

Step 630: Implement FEC decoding on the sorted FEC codeword. In the decoding process, a major bit and the 64-bit information data in the information blocks Si are recovered, and the redundant check information (namely, block Pi) is removed. As shown in FIG. 7, the information after FEC decoding includes only information blocks $S_i$ and a major bit in the sync header of the information blocks $S_i$.

Step 640: The information decoded through FEC is segmented, namely, divided into K segments. Each segment includes 64-bit information data, and a major bit in the sync header.

Step 650: Line decoding is performed for the segmented K information blocks. Specifically, 64b/66b line decoding is performed on the minor bit in the sync header, the major bit in the sync header, and the information data in the information blocks obtained from FEC decoding. In the line decoding, the type of the 64-bit information data is determined according to the major bit in the sync header. The minor bit in the sync header is obtained at the time of receiving, or derives from negation of the major bit obtained after the FEC decoding. FIG. 7 shows the information after line encoding.

Step 660: The information after line decoding is descrambled, and the descrambled information is transmitted to the reconciliation sublayer through an XGMII.

The bits for the only purpose of block synchronization are minor bits and are not involved in FEC encoding and decoding, which does not affect the system performance because the block synchronization is performed before FEC decoding. Nevertheless, the information that needs to be protected by the FEC encoding is reduced, and a higher encoding gain is obtained with the same size of check blocks. Because the bit indicative of the data type is protected through FEC encoding, higher encoding gains improve the probability of determining the data type correctly.

The third embodiment of the present invention relates to a method for encoding and transmitting data. The third embodiment is almost the same as the first embodiment, but differs in that: In the first embodiment, the length of the information involved in FEC encoding is 65*K bits, which comply with the length required for FEC encoding; in the third embodiment, the length required for FEC encoding is 66*K bits, and therefore, K predetermined padding bits (all 0s or all 1s) need to be inserted into a predetermined position of the sequence including the information data and the major bit so that the length of the sequence complies with the length required for FEC encoding.

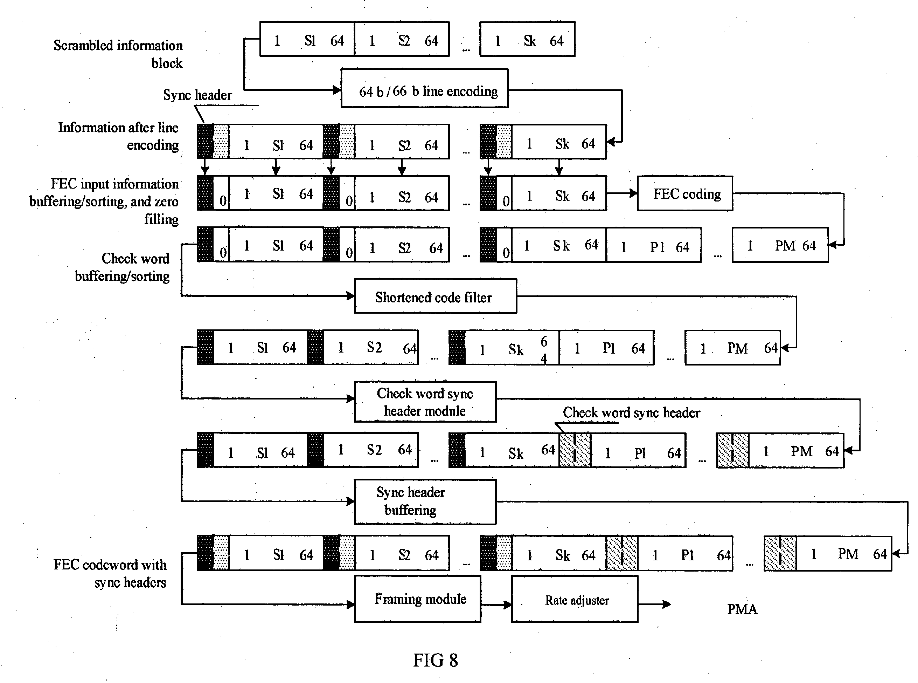

Specifically, a manufacturer generally configures only one type of FEC encoder with a fixed rate and a fixed data length in the process of developing hardware. For example, the data length involved in FEC encoding is 66*K bits. The configuration of the data length required by such a FEC encoding mode assumes that all the codewords after the 64b/ 66b line encoding are involved in the FEC encoding. Therefore, when the quantity of information blocks reaches K, the total of information data length (64*K bits) and the major bit length (K bits) is shorter than the required length (66*K bits) . In this embodiment, a predetermined padding bit (such as 0) is inserted between the major bit and the information data (namely, at the original position of the minor bit) in each information block. In this way, when the quantity of information blocks reaches K, the length required by FEC encoding is fulfilled. The "0" is padded into the specific position of the information blocks. Therefore, after FEC encoding, the padding "0" in the information may be removed through a shortened encode filter. The "0" is not transmitted on the channel, as shown in FIG. 8.

Only 65 bits need to be verified, and the padding "0" enhances the constraint relation between the check block and the information to be decoded. Compared with the scenario of verifying 66 bits, this embodiment brings a higher encoding gain with the same size of check information.

Corresponding to the method for encoding and transmitting data in the third embodiment, the fourth embodiment of the present invention relates to a method for receiving and decoding data. The fourth embodiment is almost the same as the second embodiment, but differs in that: In the fourth embodiment, after the minor bit is removed and before the FEC decoding is performed for the sequence including information and the major bit, K predetermined bits padded at the sender need to be inserted into a predetermined position of the sequence so that the length of the sequence increases to the length required by FEC decoding. That is, a 0 is padded in the position of the minor bit of the sync header, and then FEC decoding is performed for the sequence in which K 0s are padded. After the FEC decoding, the padding bit "0" is removed from the decoding result.

Evidently, in the third and fourth embodiments, when the sum of the length of the major bit in the information blocks and the length of the information data is shorter than the length required for FEC encoding or decoding, predetermined padding bits are padded to make up the length required, and then the FEC encoding or decoding is performed. In this way, the length requirement is fulfilled even if the length of the FEC encoding or decoding is fixed but greater than the total length of the major bits and the information data in the information blocks. Because fewer bits need to be protected and the newly added padding bits are known beforehand, the constraint relation between the check information and the information to be protected is enhanced, and a higher encoding gain is generated with the same size of check information.

The FEC encoding is performed only when the buffered information blocks $S_i$ to be transmitted are enough for making up a FEC encoding frame. In this embodiment, when the buffered data are not enough, padding blocks are padded into the buffer to trigger the FEC encoding in time and shorten the communication delay. After the FEC encoding, the padding blocks are removed from the encoding result, thus avoiding transmission of unnecessary data.

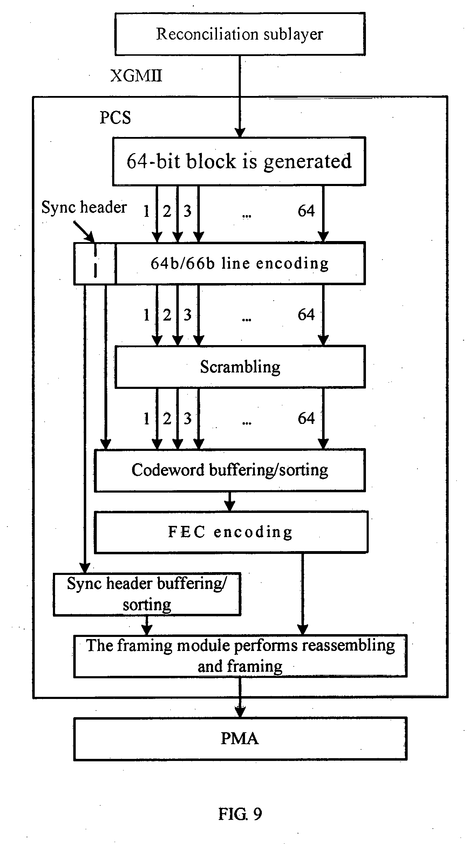

The fifth embodiment of the present invention relates to a method for encoding and transmitting data. The fifth embodiment is almost the same as the first embodiment, but differs in that: In the first embodiment, the sender scrambles the information blocks, and then performs 64b/66b line encoding; in the fifth embodiment, the sender performs 64b/66b line encoding for the information blocks and then scrambles the information blocks. That is, the sender performs 64b/66b line encoding for the information blocks, configures a sync header, and then scrambles the 64-bit information data that has undergone the 64b/66b line encoding. The major bit in the sync header that carries information type is transmitted to a codeword buffering/sorting module for buffering and sorting. The minor bit in the sync header is transmitted to a sync header buffering/sorting module for buffering and sorting. The remaining part of the process is the same as that in the first embodiment, as shown in FIG. 9. Accordingly, the receiver needs to descramble the 64-bit information data in the information blocks first, and then perform 64b/66b line decoding.

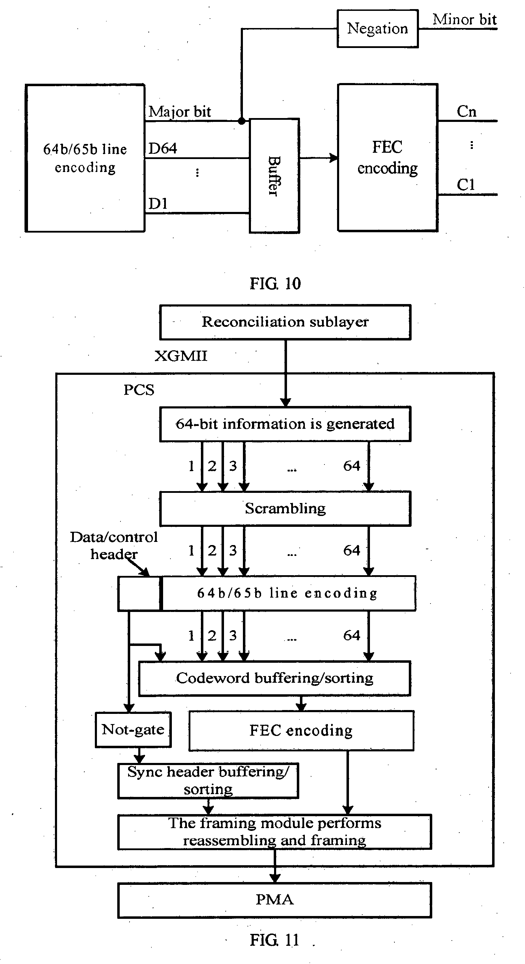

The sixth embodiment of the present invention relates to a method for encoding and transmitting data. The sixth embodiment is almost the same as the first embodiment, but differs in that: In the first embodiment, the sender performs 64b/66b line encoding; in the sixth embodiment, the sender performs 64b/65b line encoding. That is, the 64-bit information data in the information blocks after 64b/65b line encoding and a generated bit (major bit) indicative of the data type are sent into a buffer as input data bits of the FEC encoder. When the data bits in the buffer constitute a FEC encoding data frame, such bits are sent into the FEC encoder together for encoding, and the major bit generated after the 64b/65b line encoding is negated to obtain the minor bit in the sync header, as shown in FIG. 10. Accordingly, 64b/65b line encoding is also applied at the receiver, and the type of the information data is determined according to the major bit in the sync header at the time of line decoding.

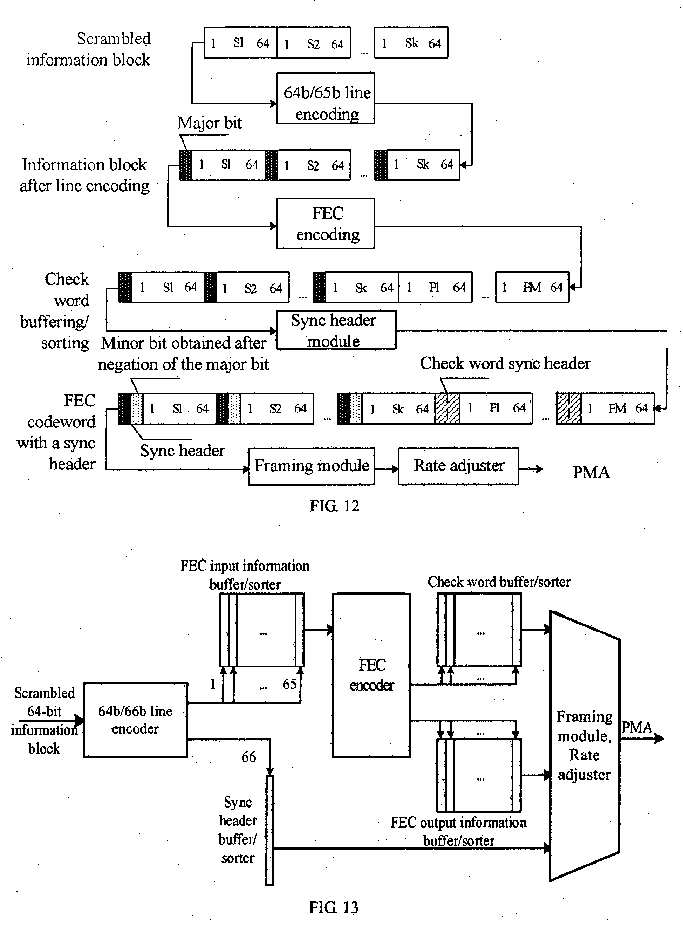

As shown in FIG. 11, the process of this embodiment is: 64b/65b line encoding is performed for the scrambled information blocks; in the process of line encoding, a 1-bit data/control header (namely, major bit) is generated according to the data type of the information blocks. The 64-bit information data that has undergone the 64b/65b line encoding and the major bit are buffered and sorted. After the major bit is sent to a not-gate to be negated, a minor bit is obtained. The minor bit is transmitted to the sync header buffering/sorting module, and the sync header buffering/sorting module buffers and sorts the minor bit in each information block. The remaining process is the same as that in the first embodiment, and is not repeated here any further. FIG. 12 shows the process of operating the information blocks in this embodiment.

This embodiment takes the 64b/65b line encoding as an example. In practice, 32b/33b line encoding is also applicable. Therefore, this embodiment is flexibly accomplishable.

The seventh embodiment of the present invention relates to an apparatus for encoding and transmitting data. The apparatus includes: a FEC encoding module, adapted to: perform FEC encoding for the information data of information blocks to be transmitted and for M major bits in the block header of the information blocks, and generate check blocks; and a sending module, adapted to send the information blocks and the check blocks corresponding to the information blocks, where all bits in the block header of the information blocks are sorted into M major bits and N minor bits according to importance beforehand, each information block includes a block header and information data, and the size of the block header is M+N (M and N are integers, $M \geq 0$, $N \geq 1$). In this embodiment, the block header is a sync header, and includes two bits designed for block synchronization. Of the two bits, one is designed not only for block synchronization, but also for indicating the type of the information data in the same information blocks. This bit is a major bit, and the other bit is a minor bit. Besides, the apparatus in this embodiment also includes a scrambling module, a line encoding module, and a buffering and sorting module.

The scrambling module is adapted to scramble the information data. The line encoding module is adapted to: perform line encoding for the information data, generate a sync header (the sync header is placed at the head or end of the information), output the information data and the major bit of the sync header to the FEC encoding module, and output the minor bit in the sync header together with the result of the FEC encoding module that processing the same information blocks to a sending module. The buffering and sorting module is adapted to buffer and sort the information that needs to be input into the FEC encoding module.

Specifically, as shown in FIG. 13, the line encoding module (namely, the 64b/ 66b line encoder in the figure) performs line encoding for the scrambled 64- bit information data. The line encoder adds the corresponding sync header (the sync header may be placed at the head or end of the information) according to the information type, and then the 64b/ 66b line encoder transmits the 66- bit information that has undergone line encoding to the corresponding buffer/ sorter. The 64- bit information data and the major bit of the generated sync header are transmitted to the buffering and sorting module (namely, the FEC input information buffer/ sorter in the figure) . The information that needs to be input into the FEC encoding module is buffered and sorted, and the other minor bit in the sync header is transmitted to the sync header buffer/ sorter. Each buffer/ sorter stores data according to certain rules.

When the data stored in the FEC input information buffer/sorter reaches the information length "65*K" required by the FEC encoding module (namely, the FEC encoder in the figure), the FEC input information buffer transmits this dataset to the FEC encoder sequentially, and then begins to receive and store new information blocks. Meanwhile, the sync header buffer transmits the sync data whose length is K to the sending module (namely, the framing module and the rate adjuster in the figure). The sending module stores the K minor bits to the corresponding position of the information blocks according to certain rules.

After receiving the dataset, the FEC encoder encodes the dataset according to certain encoding rules, and generates the corresponding check word. Upon completion of the FEC encoding, the FEC encoder transmits the dataset to the FEC output information buffer/sorter (or to the sending module directly). Meanwhile, the FEC encoder transmits the check word to a check word buffer/sorter (alternatively, the FEC encoder transmits the check word to the check word 64b/66b line encoder first, adds a sync header, and then transmits the check word with an added sync header to the check word buffer/sorter). After the FEC output information buffer/sorter and the check word buffer/sorter is full of received data, the data is transmitted to the sending module. The framing module in the sending module performs reassembling and framing of the information to be  sent, and the rate adjuster in the sending module performs rate adjustment for the framed information, and sends the information to the PMA for further sending.

In this embodiment, because only a major bit in the sync header is involved in the FEC encoding, a higher encoding gain is obtained with the same size of check blocks. Because the major bit indicative of the data type is protected through FEC encoding, higher encoding gains improve the probability of determining the data type correctly.

In this embodiment, the 64b/66b line encoder performs line encoding for the scrambling result output by the scrambling module. In practice, it is practicable that the 64b/66b line encoder performs line encoding first, the scrambling module scrambles the resulted output by the 64b/66b line encoder, and the scrambling result is sent to the FEC input information buffer/sorter for buffering or sorting and output to the FEC encoder.

Besides, if the sum of the length (Y) of the information data of the information blocks and the quantity (M) of major bits is shorter than the length (Z) required for FEC encoding, the data transmitting apparatus in this embodiment may also include a padding module and a filter. The padding module is adapted to: buffer the sequence including the information data and the major bits that need to be input into the FEC encoding module, and insert Z- Y- M (Z minus Y minus M) predetermined padding bits in a predetermined position of the sequence. In this way, the length of the sequence increases to Z, and the length requirement is fulfilled in the case that the length of the FEC encoding or decoding is fixed but longer than the sum of the length of the major bits and the length of the information data (Y and Z are positive integers) of the information blocks. Afterward, the sequence is output to the FEC encoding module. The filter is adapted to remove padding bits out of the encoding result output by the FEC encoding module, and then output the coded result to the sending module.

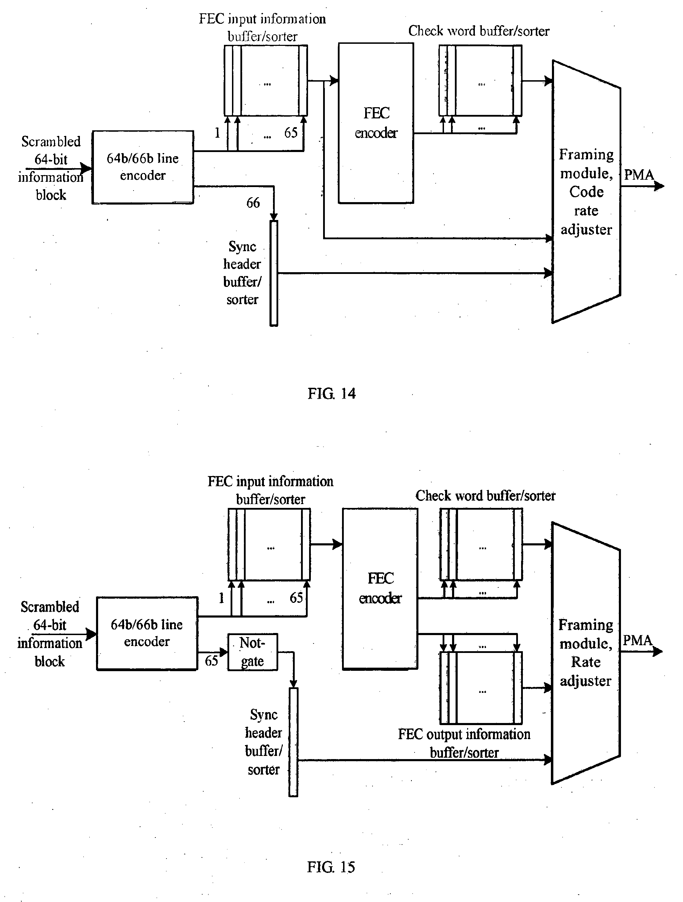

The eighth embodiment of the present invention relates to an apparatus for encoding and transmitting data. The eighth embodiment is almost the same as the seventh embodiment, but differs in that: In the seventh embodiment, the FEC encoder transmits the coded information data to a FEC output information buffer/sorter, and transmits the check word to a check word buffer/sorter at the same time, and the data is transmitted to a sending module after the FEC output information buffer/sorter is full of received data; in this embodiment, after the length of the data stored in the FEC input information buffer/sorter reaches the information length "65*K" required by the FEC encoder, the dataset is transmitted to the FEC encoder sequentially as well as to the sending module for framing. FIG. 14 shows a structure of the apparatus in this embodiment. Compared with the apparatus in the seventh embodiment, the apparatus in this embodiment is simpler.

The ninth embodiment of the present invention relates to an apparatus for encoding and transmitting data. The ninth embodiment is almost the same as the seventh embodiment, but differs in that: In the seventh embodiment, the line encoding module is a 64b/66b line encoder; in the ninth embodiment, the line encoding module is a 64b/65b line encoder. Therefore, the line encoding module is adapted to perform line encoding for information data and generate major bits in the sync header, and output the information data and the major bits in the sync header to the FEC encoding module. Besides, the apparatus in this embodiment also includes a negating module. The negating module is adapted to perform a negation operation for the major bits in the sync header output by the 64b/65b line encoder. The result of the negation operation and the processing result of the FEC encoding module for the same information blocks are output together to the sending module.

Specifically, as shown in FIG. 15, the 64b/ 65b line encoder performs line encoding for the scrambled 64- bit information data. The 64b/ 65b line encoder generates a 1- bit data/ control header (namely, major bit that carries data type information) according to the information type, and transmits the major bit to the FEC input information buffer/ sorter. Afterward, the major bit is sent to a NOT- gate, and then to a sync header buffer/ sorter. The 64b/ 66b line encoder also needs to transmit the 64- bit information data that has undergone line encoding and a major bit to the FEC input information buffer/ sorter. The remaining apparatuses are the same as those in the seventh embodiment, and are not repeated here any further.

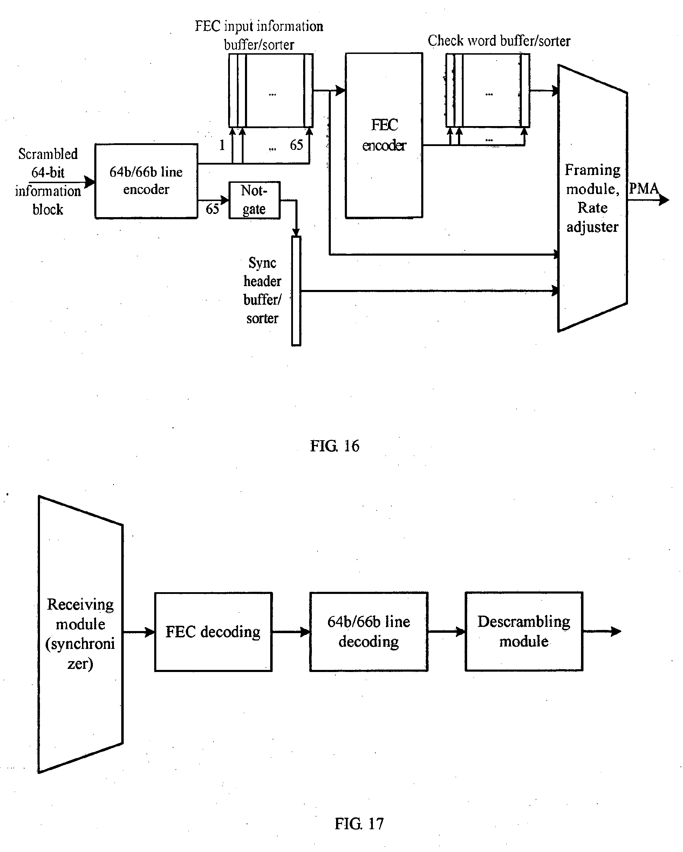

The 10th embodiment of the present invention relates to an apparatus for encoding and transmitting data. The 10th embodiment is almost the same as the ninth embodiment, but differs in that: In the ninth embodiment, the FEC encoder transmits the coded information data to a FEC output information buffer/sorter and transmits the check word to a check word buffer/sorter at the same time, and the data is transmitted to a sending module after the FEC output information buffer/sorter is full of received data; in this embodiment, after the length of the data stored in the FEC input information buffer/sorter reaches the information length "65*K" required by the FEC encoder, the dataset is transmitted to the FEC encoder sequentially and also to the sending module sequentially for framing. FIG. 16 shows a structure of the apparatus in this embodiment.

The 11th embodiment of the present invention relates to an apparatus for decoding and receiving data. The apparatus includes: a receiving module, adapted to receive information blocks and the check blocks corresponding to the information blocks; and a FEC decoding module, adapted to perform FEC decoding for the information data of the received information blocks and for M major bits in the block header of the received information blocks by using check blocks, where N minor bits in the block header of the information blocks are not involved in the FEC decoding. All bits in the block header of the information blocks are sorted into M major bits and N minor bits according to importance beforehand, each information block includes a block header and information data, and the size of the block header is M+N (M and N are integers, M ≥ 0, N ≥ 1). In this embodiment, the block header is a sync header, and includes two bits designed for block synchronization. Of the two bits, one is designed not only for block synchronization, but also for indicating the type of the information data in the same information blocks. This bit is a major bit, and the other bit is a minor bit. Besides, the apparatus in this embodiment also includes a decoding module and a descrambling module.

Specifically, as shown in FIG. 17, a synchronizer in the receiving module receives information blocks and the check blocks corresponding to the information blocks. The synchronizer is adapted to perform block synchronization for the received information according to the sync header of the information blocks, and obtain information blocks and the check blocks corresponding to the information blocks according to the result of block synchronization. Afterward, the receiving module transmits the received information blocks and the check blocks corresponding to the information blocks to a FEC decoding module. The FEC decoding module decodes the information data in the information blocks and the major bits that carries data type information in the block header, and transmits the decoding result to a line decoding module, namely, the 64b/ 66b line decoder in the figure. The 64b/ 66b line decoder is adapted to perform line decoding for the minor bit in the sync header, the information data in the information blocks output by the FEC decoding module, and the major bit in the sync header of the information blocks. In the line decoding, the type of the information data is determined according to the major bit in the sync header.

The receiving module of the 64b/66b line decoder transmits the minor bit to the line decoder directly. Alternatively, the apparatus includes a converting module, which is adapted to: negate the major bit output by the FEC decoding module, and output the negation result as a minor bit to the 64b/66b line decoder so that the 64b/66b line decoder obtains this minor bit.

Afterward, the 64b/ 66b line decoder outputs the result of line decoding to a descrambling module. The descrambling module descrambles the information data.

In this embodiment, the descrambling module descrambles the information output by the 64b/66b line decoder. In practice, depending on the sequence of line encoding and scrambling for the information blocks in the sender, the descrambling module may also descramble the information data output by the FEC decoding module first, and then output the descrambling result to the 64b/66b line decoder which performs line decoding.

Besides, if the sum of the length (Y) of the information data in the information blocks and the quantity (M) of major bits is shorter than the length (Z) required for FEC decoding, the apparatus in this embodiment may also include a padding module and a filter. The padding module is adapted to: buffer the sequence including the information data and the major bits that need to be input into the FEC encoding module, and insert Z- Y- M (Z minus Y minus M) predetermined padding bits in a predetermined position of the sequence. In this way, the length of the sequence increases to Z (Y and Z are positive integers) . Afterward, the sequence is output to the FEC decoding module for decoding. The filter is adapted to remove padding bits out of the decoding result output by the FEC decoding module.

The 12th embodiment of the present invention relates to an apparatus for decoding and receiving data. The 12th embodiment is almost the same as the 11th embodiment, but differs in that: In the 11th embodiment, the line decoding module is a 64b/66b line decoder; in the 12th embodiment, the line decoding module is a 64b/65b line decoder. Therefore, the line decoding module is adapted to perform line decoding for the information data in the information blocks output by the FEC decoding module, and the major bit in the sync header of the information blocks. In the line decoding, the type of the information data is determined according to the major bit in the sync header.

In summary, in the embodiments of the present invention, the minor bits in block header of the information blocks are not involved in the FEC encoding. Therefore, fewer important information bits are protected by the same size of check blocks, and the FEC encoding obtains a higher encoding gain and reduces error probability of important information bits. Compared with the prior art, the technical solution under the present invention obtains a higher encoding gain without increasing the implementation complexity, and therefore, increases the power budget of the 10G EPON system.

The block header may be a sync header. The bit indicative of the data type serves as a major bit, and is protected through FEC encoding. The bit for the only purpose of block synchronization serves as a minor bit, which is not involved in the FEC encoding and decoding. The block synchronization is performed by FEC decoding. Therefore, the bit for the only purpose of block synchronization is not involved in FEC encoding and decoding, which does not affect the system performance. Nevertheless, the information that needs to be protected by the FEC encoding is reduced, and a higher encoding gain is obtained with the same size of check blocks. Because the bit indicative of the data type is protected through FEC encoding, higher encoding gains improve the probability of determining the data type correctly.

All the bits of the sync header may be generated through line encoding like 64b/66b or 32b/34b. Optionally, after the line encoding like 64b/65b or 32b/33b is performed, the bit indicative of the data type is negated to obtain the other bit in the sync header, thus making the implementation of the present invention flexible.

The scrambling of information data maximally ensures that the transmitted information has enough transition, and facilitates clock recovery.

When the sum of the length of the quantity of the major bits and the length of information data of the information blocks is shorter than the length required by FEC encoding or decoding, predetermined padding bits (such all 0s or all 1s) may be padded to make up the length required, and then the FEC encoding or decoding is performed. In this way, the length requirement is fulfilled even if the length of the FEC encoding or decoding is fixed but greater than the total length of the major bits and the information data in the information blocks. Because fewer bits need to be protected and the newly added padding bits are known beforehand, the constraint relation between the check information and the information to be protected is enhanced, and a higher encoding gain is generated with the same size of check information.

After the FEC encoding or decoding, the padding bits may be removed out of the encoding or decoding result, thus reducing unnecessary transmission of the padding bits in other processing steps.

Although the invention has been described through some preferred embodiments and accompanying drawings, the invention is not limited to such embodiments. It is apparent that those skilled in the art can make various modifications and variations to the invention without departing from the scope of the claim.

**Claims**

1. A method for encoding and transmitting data, said data comprising information blocks and check blocks,
   each information block comprising a block header and information data, wherein the block header is a sync header comprising a major bit and a minor bit, the major bit of the sync header used for block synchronization and indicating the type of the information data of the block, and the minor bit of the sync header used for block synchronization; the method comprising:

performing Forward Error Correction, FEC, encoding on the information data and the major bit in the block header of each information block, the minor bit in the block header of each information block not involved in the FEC encoding;
generating said check blocks by said FEC encoding; and
sending the information blocks and the check blocks.

2. The method for encoding and transmitting data according to claim 1, before performing FEC encoding, the method further comprises:

performing line encoding on the information data, and
generating the major bit and the minor bit in the sync header.

3. The method for encoding and transmitting data according to claim 1, before performing FEC encoding, the method further comprises:

performing line encoding on the information data;
generating the major bit in the sync header;
negating the major bit to obtain the minor bit in the sync header.

4. The method for encoding and transmitting data according to anyone of claims 1 to 3, before performing FEC encoding, the method further comprising:

scrambling the information data.

5. The method for encoding and transmitting data according to anyone of claims 1 to 4, if the total length of the information data and the major bits is shorter than the length required for FEC encoding, the method further comprising:

adding predetermined padding bits to the sequence comprising the information data and the major bits before performing FEC encoding, wherein the total length of the information data, the major bits and the added predetermined padding bits is equal to the length required for the FEC encoding, and the information data, the major bits and the added predetermined padding bits are used for the FEC encoding to generate the check blocks; and
after performing FEC encoding, removing the added predetermined padding bits from FEC encoding result.

6. A method for receiving and decoding data, said data comprising information blocks and check blocks, each information block comprising a block header and information data, wherein the block header is a sync header comprising a major bit and a minor bit, the major bit of the sync header used for block synchronization and indicating the type of the information data of the block, and the minor bit of the sync header used for block synchronization; the method comprising:

receiving the information blocks and the check blocks;
performing Forward Error Correction, FEC, decoding on the information data and the major bit in the block header of each received information block with the check blocks, the minor bit in the block header of each information block not involved in the FEC decoding.

7. The method for receiving and decoding data according to claim 6, after performing FEC decoding, the method further comprising:

performing line decoding on information block comprising the minor bit, the information data and the major bit after FEC decoding;
wherein the type of the information data is determined according to the major bit during line decoding and the minor bit involved in line decoding is obtained by receiving or by negating the major bit obtained by FEC decoding.

8. The method for receiving and decoding data according to claim 6, after performing FEC decoding, the method further comprises:

performing line decoding on the information data and the major bit after FEC decoding;
wherein the type of the information data is determined according to the major bit during line decoding.

9. The method for receiving and decoding data according to anyone of claims 6 to 8, after performing FEC decoding, the method further comprising:

descrambling the information data.

10. The method for receiving and decoding data according to anyone of claims 6 to 9, if the total length of the information data and the major bits is shorter than the length required for FEC decoding, the method further comprising:

adding predetermined padding bits to the sequence comprising the information data and the major bits before performing FEC decoding, wherein the total length of the information data, the major bits and the added predetermined padding bits is equal to the length required for the FEC decoding, and the information data, the major bits and the added predetermined padding bits are used for the FEC decoding with the check blocks; and after performing FEC decoding, removing the added predetermined padding bits from FEC decoding result.

11. An apparatus for encoding and transmitting data, comprising:

a Forward Error Correction, FEC, encoding module, configured to perform FEC encoding on information data and a major bit in a block header of information blocks, a minor bit in the block header of the information blocks not involved in the FEC encoding, and generate check blocks by said FEC encoding; and
a sending module, configured to send the information blocks and the check blocks;
wherein each information block comprises the block header and the information data, wherein the block header is a sync header comprising the major bit and the minor bit, the major bit of sync header used for block synchronization and indicating the type of the information data of the block, and the minor bit of sync header used for block synchronization.

12. The apparatus for encoding and transmitting data according to claim 11, the apparatus further comprises:

a first line encoding module, configured to perform line encoding on the information data to generate the major bit and the minor bit in the sync header, output the information data and the major bit to the FEC encoding module, and output the minor bit with the result of the FEC encoding module to the sending module.

13. The apparatus for encoding and transmitting data according to claim 11, the apparatus further comprises:

a second line encoding module, configured to perform line encoding on the information data to generate the major bit, and output the information data and the major bit to the FEC encoding module;
a negating module, configured to negate the major bits output by the second line encoding module, and output the negating result with the processing result of the FEC encoding module to the sending module.

14. The apparatus for encoding and transmitting data according to claim 11 or 13, the apparatus further comprising:

a scrambling module, configured to scramble the information data;
wherein the scrambling result is output to the first line encoding module or the second line encoding module, or the scrambling module scrambles the information data output by the first line encoding module or the second line encoding module and then outputs the scrambling result to the FEC encoding module.

15. The apparatus for encoding and transmitting data according to anyone of claims 11 to 14, if the total length of the information data and the major bits is shorter than the length required for FEC encoding, the apparatus further comprising:

a padding module, configured to buffer the sequence comprising the information data and the major bits, and insert predetermined padding bits in a predetermined position of the sequence, and then output the information data, the major bits and the inserted predetermined padding bits to the FEC encoding module, wherein the total length of the information data, the major bits and the inserted predetermined padding bits is equal to the length required for the FEC encoding;

a filter, configured to remove the inserted predetermined padding bits from the encoding result output by the FEC encoding module, and then output to the sending module.

16. An apparatus for receiving and decoding data, comprising:

a receiving module, configured to receive information blocks and check blocks; and

a Forward Error Correction, FEC, decoding module, configured to perform FEC decoding on information data and a major bit in a block header of the received information block with the check blocks, a minor bit in the block header of the information blocks not involved in the FEC decoding;

wherein each the information block comprises the block header and the information data, wherein the block header is a sync header comprising the major bit and the minor bit, the major bit of sync header used for block synchronization and indicating the type of the information data of the block, and the minor bit of sync header used for block synchronization.

17. The apparatus for receiving and decoding data according to claim 16, the apparatus further comprising:

a first line decoding module, configured to perform line decoding on the information blocks comprising the minor bit, the information data and the major bit after FEC decoding, wherein the type of the information data is determined according to the major bit during line decoding and the minor bit involved in line decoding is output by the receiving module or obtained by negating the major bit of the information blocks output by the FEC decoding module.

18. The apparatus for receiving and decoding data according to claim 16, the apparatus further comprises:

a second line decoding module, configured to perform line decoding on the information data and the major bit of the information blocks after FEC decoding, wherein the type of the information data is determined according to the major bit during line decoding.

19. The apparatus for receiving and decoding data according to anyone of claims 16 to 18, the apparatus further comprising:

a descrambling module, configured to descramble the information data;

wherein the descrambling module descrambles the information data output by the first line decoding module or the second line decoding module, or the descrambling module descrambles the information data output by the FEC decoding module and then outputs the descrambling result to the first line decoding module or the second line decoding module.

20. The apparatus for receiving and decoding data according to anyone of claims 16 to 19, if the total length of the information data and the major bits is shorter than the length required for FEC decoding, the apparatus further comprising:

a padding module, configured to buffer the sequence comprising the information data and the major bits, and insert predetermined padding bits in a predetermined position of the sequence, and then output the information data, the major bits and the inserted predetermined padding bits to the FEC decoding module, wherein the total length of the information data, the major bits and the added predetermined padding bits is equal to the length required for the FEC decoding; and

a filter, configured to remove the inserted predetermined padding bits from the decoding result output by the FEC decoding module.

**Patentansprüche**

1. Verfahren zum Codieren und Übertragen von Daten, wobei die Daten Informationsblöcke und Prüfblöcke umfassen, wobei jeder Informationsblock einen Block-Header und Informationsdaten umfasst, wobei der Block-Header ein Sync-Header mit einem Majoritätsbit und einem Minoritätsbit ist, das Majoritätsbit des Sync-Headers zur Blocksynchronisation verwendet wird und die Art der Informationsdaten des Blocks angibt und das Minoritätsbit des Sync-Headers zur Blocksynchronisation verwendet wird;
wobei das Verfahren Folgendes umfasst:

Ausführen von Vorwärtsfehlerkorrektur-Codierung, FEC-Codierung, an den Informationsdaten und dem Majoritätsbit in dem Block-Header jedes Informationsblocks, wobei das Minoritätsbit in dem Block-Header jedes Informationsblocks nicht an der FEC-Codierung beteiligt ist;
Erzeugen der Prüfblöcke durch die FEC-Codierung; und
Senden der Informationsblöcke und der Prüfblöcke.

2.  Verfahren zum Codieren und Übertragen von Daten nach Anspruch 1, wobei das Verfahren vor dem Ausführen der FEC-Codierung ferner Folgendes umfasst:

Ausführen von Leitungscodierung an den Informationsdaten und
Erzeugen des Majoritätsbit und des Minoritätsbit in dem Sync-Header.

3.  Verfahren zum Codieren und Übertragen von Daten nach Anspruch 1, wobei das Verfahren vor dem Ausführen der FEC-Codierung ferner Folgendes umfasst:

Ausführen von Leitungscodierung an den Informationsdaten;
Erzeugen des Majoritätsbit in dem Sync-Header;
Negieren des Majoritätsbit, um das Minoritätsbit in dem Sync-Header zu erhalten.

4.  Verfahren zum Codieren und Übertragen von Daten nach einem der Ansprüche 1 bis 3, wobei das Verfahren vor dem Ausführen der FEC-Codierung ferner Folgendes umfasst:

Verwürfeln der Informationsdaten.

5.  Verfahren zum Codieren und Übertragen von Daten nach einem der Ansprüche 1 bis 4, wobei das Verfahren, wenn die Gesamtlänge der Informationsdaten und der Majoritätsbit kürzer als die zur FEC-Codierung erforderliche Länge ist, ferner Folgendes umfasst:

Hinzufügen von vorbestimmten Stopfbit zu der die Informationsdaten und die Majoritätsbit umfassende Sequenz vor dem Ausführen der FEC-Codierung, wobei die Gesamtlänge der Informationsdaten, der Majoritätsbit und der hinzugefügten vorbestimmten Stopfbit gleich der für die FEC-Codierung erforderlichen Länge ist und die Informationsdaten, die Majoritätsbit und die hinzugefügten vorbestimmten Stopfbit für die FEC-Codierung verwendet werden, um die Prüfblöcke zu erzeugen; und
nach dem Ausführen der FEC-Codierung, Entfernen der hinzugefügten vorbestimmten Stopfbit aus dem FEC-Codierungsergebnis.

6.  Verfahren zum Empfangen und Decodieren von Daten, wobei die Daten Informationsblöcke und Prüfblöcke umfassen,
wobei jeder Informationsblock einen Block-Header und Informationsdaten umfasst, wobei der Block-Header ein Sync-Header mit einem Majoritätsbit und einem Minoritätsbit ist, das Majoritätsbit des Sync-Headers zur Blocksynchronisation verwendet wird und die Art der Informationsdaten des Blocks angibt und das Minoritätsbit des Sync-Headers zur Blocksynchronisation verwendet wird;
wobei das Verfahren Folgendes umfasst:

Empfangen der Informationsblöcke und der Prüfblöcke;
Ausführen von Vorwärtsfehlerkorrektur-Decodierung, FEC-Decodierung, an den Informationsdaten und dem Majoritätsbit in dem Block-Header jedes empfangenen Informationsblocks mit den Prüfblöcken, wobei das Minoritätsbit in dem Block-Header jedes Informationsblocks nicht an der FEC-Decodierung beteiligt ist.

7.  Verfahren zum Empfangen und Decodieren von Daten nach Anspruch 6, wobei das Verfahren nach dem Ausführen der FEC-Decodierung ferner Folgendes umfasst:

Ausführen von Leitungsdecodierung am Informationsblock mit dem Minoritätsbit, den Informationsdaten und dem Majoritätsbit nach der FEC-Decodierung;
wobei die Art der Informationsdaten gemäß dem Majoritätsbit während der Leitungsdecodierung bestimmt wird und das an der Leitungsdecodierung beteiligte Minoritätsbit durch Empfangen oder durch Negieren des durch FEC-Decodierung erhaltenen Majoritätsbit erhalten wird.

8. Verfahren zum Empfangen und Decodieren von Daten nach Anspruch 6, wobei das Verfahren nach dem Ausführen der FEC-Decodierung ferner Folgendes umfasst:

Ausführen von Leitungsdecodierung an den Informationsdaten und dem Majoritätsbit nach der FEC-Decodierung;
wobei die Art der Informationsdaten gemäß dem Majoritätsbit während der Leitungsdecodierung bestimmt wird.

9. Verfahren zum Empfangen und Decodieren nach einem der Ansprüche 6 bis 8, wobei das Verfahren nach dem Ausführen der FEC-Decodierung ferner Folgendes umfasst:

Entwürfeln der Informationsdaten.

10. Verfahren zum Empfangen und Decodieren von Daten nach einem der Ansprüche 6 bis 9, wobei das Verfahren, wenn die Gesamtlänge der Informationsdaten und der Majoritätsbit kürzer als die zur FEC-Decodierung erforderliche Länge ist, ferner Folgendes umfasst:

Hinzufügen von vorbestimmten Stopfbit zu der die Informationsdaten und die Majoritätsbit umfassenden Sequenz vor dem Ausführen der FEC-Decodierung, wobei die Gesamtlänge der Informationsdaten, der Majoritätsbit und der hinzugefügten Stopfbit gleich der für die FEC-Decodierung erforderlichen Länge ist und die Informationsdaten, die Majoritätsbit und die hinzugefügten vorbestimmten Stopfbit für die FEC-Decodierung mit den Prüfblöcken verwendet werden; und
Entfernen der hinzugefügten vorbestimmten Stopfbit aus dem FEC-Decodierungsergebnis nach dem Ausführen der FEC-Decodierung.

11. Vorrichtung zum Codieren und Übertragen von Daten, umfassend:

ein Vorwärtsfehlerkorrektur-Codierungsmodul, FEC-Codierungsmodul, ausgelegt zum Ausführen von FEC-Codierung an Informationsdaten und einem Majoritätsbit in einem Block-Header von Informationsblöcken, wobei ein Minoritätsbit in dem Block-Header der Informationsblöcke nicht an der FEC-Codierung beteiligt ist, und Erzeugen von Prüfblöcken durch die FEC-Codierung; und
ein Sendemodul, ausgelegt zum Senden der Informationsblöcke und der Prüfblöcke;
wobei jeder Informationsblock den Block-Header und die Informationsdaten umfasst, wobei der Block-Header ein Sync-Header mit dem Majoritätsbit und dem Minoritätsbit ist, das Majoritätsbit des Sync-Headers zur Blocksynchronisation verwendet wird und die Art der Informationsdaten des Blocks angibt und das Minoritätsbit des Sync-Headers zur Blocksynchronisation verwendet wird.

12. Vorrichtung zum Codieren und Übertragen von Daten nach Anspruch 11, wobei die Vorrichtung ferner Folgendes umfasst:

ein erstes Leitungscodierungsmodul, ausgelegt zum Ausführen von Leitungscodierung an den Informationsdaten, um das Majoritätsbit und das Minoritätsbit in dem Sync-Header zu erzeugen, Ausgeben der Informationsdaten und des Majoritätsbit an das FEC-Codierungsmodul und Ausgeben des Minoritätsbit mit dem Ergebnis des FEC-Codierungsmoduls an das Sendemodul.

13. Vorrichtung zum Codieren und Übertragen von Daten nach Anspruch 11, wobei die Vorrichtung ferner Folgendes umfasst:

ein zweites Leitungscodierungsmodul, ausgelegt zum Ausführen von Leitungscodierung an den Informationsdaten, um das Majoritätsbit zu erzeugen, und Ausgeben der Informationsdaten und des Majoritätsbit an das FEC-Codierungsmodul; und
ein Negierungsmodul, ausgelegt zum Negieren der durch das zweite Leitungscodierungsmodul ausgegebenen Majoritätsbit und Ausgeben des Negierungsergebnisses mit dem Verarbeitungsergebnis des FEC-Codierungsmoduls an das Sendemodul.

14. Vorrichtung zum Codieren und Übertragen von Daten nach Anspruch 11 oder 13, wobei die Vorrichtung ferner Folgendes umfasst:

ein Verwürfelungsmodul, ausgelegt zum Verwürfeln der Informationsdaten;
wobei das Verwürfelungsergebnis an das erste Leitungscodierungsmodul oder das zweite Leitungscodierungsmodul ausgegeben wird oder das Verwürfelungsmodul die durch das erste Leitungscodierungsmodul oder das zweite Leitungscodierungsmodul ausgegebenen Informationsdaten verwürfelt und das Verwürfelungsergebnis dann an das FEC-Codierungsmodul ausgibt.

15. Vorrichtung zum Codieren und Übertragen von Daten nach einem der Ansprüche 11 bis 14, wobei die Vorrichtung, wenn die Gesamtlänge der Informationsdaten und der Majoritätsbit kürzer als die für FEC-Codierung erforderliche Länge ist, ferner Folgendes umfasst:

ein Stopfmodul, ausgelegt zum Puffern der die Informationsdaten und die Majoritätsbit umfassende Sequenz und Einfügen von vorbestimmten Stopfbit in eine vorbestimmte Position der Sequenz und dann Ausgeben der Informationsdaten, der Majoritätsbit und der eingefügten vorbestimmten Stopfbit an das FEC-Codierungsmodul, wobei die Gesamtlänge der Informationsdaten, der Majoritätsbit und der eingefügten vorbestimmten Stopfbit gleich der für die FEC-Codierung erforderlichen Länge ist;
ein Filter, ausgelegt zum Entfernen der eingefügten vorbestimmten Stopfbit aus dem durch das FEC-Codierungsmodul ausgegebenen Codierungsergebnis und dann Ausgeben an das Sendemodul.

16. Vorrichtung zum Empfangen und Decodieren von Daten, umfassend:

ein Empfangsmodul, ausgelegt zum Empfangen von Informationsblöcken und Prüfblöcken; und
ein Vorwärtsfehlerkorrektur-Decodierungsmodul, FEC-Decodierungsmodul, ausgelegt zum Ausführen von FEC-Decodierung an Informationsdaten und einem Majoritätsbit in einem Block-Header des empfangenen Informationsblocks mit den Prüfblöcken, wobei ein Minoritätsbit in dem Block-Header der Informationsblöcke nicht an der FEC-Decodierung beteiligt ist;
wobei jeder Informationsblock den Block-Header und die Informationsdaten umfasst, wobei der Block-Header ein Sync-Header mit dem Majoritätsbit und dem Minoritätsbit ist, das Majoritätsbit des Sync-Headers zur Blocksynchronisation verwendet wird und die Art der Informationsdaten des Blocks angibt und das Minoritätsbit des Sync-Headers zur Blocksynchronisation verwendet wird.

17. Vorrichtung zum Empfangen und Decodieren von Daten nach Anspruch 16, wobei die Vorrichtung ferner Folgendes umfasst:

ein erstes Leitungsdecodierungsmodul, ausgelegt zum Ausführen von Leitungsdecodierung an den das Minoritätsbit, die Informationsdaten und das Majoritätsbit umfassenden Informationsblöcken nach FEC-Decodierung, wobei die Art der Informationsdaten gemäß dem Majoritätsbit während der Leitungsdecodierung bestimmt wird und das bei der Leitungsdecodierung beteiligte Minoritätsbit durch das Empfangsmodul ausgegeben oder durch Negieren des Majoritätsbit der durch das FEC-Decodierungsmodul ausgegebenen Informationsblöcke erhalten wird.

18. Vorrichtung zum Empfangen und Decodieren von Daten nach Anspruch 16, wobei die Vorrichtung ferner Folgendes umfasst:

ein zweites Leitungsdecodierungsmodul, ausgelegt zum Ausführen von Leitungsdecodierung an den Informationsdaten und dem Majoritätsbit der Informationsblöcke nach FEC-Decodierung, wobei die Art der Informationsdaten gemäß dem Majoritätsbit während der Leitungsdecodierung bestimmt wird.

19. Vorrichtung zum Empfangen und Decodieren von Daten nach einem der Ansprüche 16 bis 18, wobei die Vorrichtung ferner Folgendes umfasst:

ein Entwürfelungsmodul, ausgelegt zum Entwürfeln der Informationsdaten;
wobei das Entwürfelungsmodul die durch das erste Leitungsdecodierungsmodul oder das zweite Leitungsdecodierungsmodul ausgegebenen Informationsdaten entwürfelt oder das Entwürfelungsmodul die durch das FEC-Decodierungsmodul ausgegebenen Informationsdaten entwürfelt und das Entwürfelungsergebnis dann an das erste Leitungsdecodierungsmodul oder das zweite Leitungsdecodierungsmodul ausgibt.

**20.** Vorrichtung zum Empfangen und Decodieren von Daten nach einem der Ansprüche 16 bis 19, wobei die Vorrichtung, wenn die Gesamtlänge der Informationsdaten und der Majoritätsbit kürzer als die für FEC-Decodierung erforderliche Länge ist, ferner Folgendes umfasst:

ein Stopfmodul, ausgelegt zum Puffern der die Informationsdaten und die Majoritätsbit umfassenden Sequenz und Einfügen von vorbestimmten Stopfbit in eine vorbestimmte Position der Sequenz und dann Ausgeben der Informationsdaten, der Majoritätsbit und der eingefügten vorbestimmten Stopfbit an das FEC-Decodierungsmodul, wobei die Gesamtlänge der Informationsdaten, der Majoritätsbit und der hinzugefügten vorbestimmten Stopfbit gleich der für die FEC-Decodierung erforderlichen Länge ist; und

ein Filter, ausgelegt zum Entfernen der eingefügten vorbestimmten Stopfbit aus dem durch das FEC-Decodierungsmodul ausgegebenen Decodierungsergebnis.

**Revendications**

**1.** Procédé de codage et de transmission de données, lesdites données comprenant des blocs d'informations et des blocs de vérification,

chaque bloc d'informations comprenant un entête de bloc et des données d'informations, l'entête de bloc étant un entête de synchronisation comprenant un bit majeur et un bit mineur, le bit majeur de l'entête de synchronisation étant utilisé pour la synchronisation des blocs et indiquant le type des données d'informations du bloc, et le bit mineur de l'entête de synchronisation étant utilisé pour la synchronisation des blocs ;

le procédé comprenant

l'exécution d'un codage de Correction d'Erreurs sans Voie de Retour, FEC (Forward Error Correction), sur les données d'informations et le bit majeur dans l'entête de bloc de chaque bloc d'informations, le bit mineur contenu dans l'entête de bloc de chaque bloc d'informations n'intervenant pas dans le codage FEC ;

la génération desdits blocs de vérification par ledit codage FEC ; et

l'envoi des blocs d'informations et des blocs de vérification.

**2.** Procédé de codage et de transmission de données selon la revendication 1, le procédé comprenant en outre, avant d'exécuter le codage FEC :

l'exécution d'un codage de ligne sur les données d'informations ; et

la génération du bit majeur et du bit mineur dans l'entête de synchronisation.

**3.** Procédé de codage et de transmission de données selon la revendication 1, le procédé comprenant en outre, avant d'exécuter le codage FEC :

l'exécution d'un codage de ligne sur les données d'informations ;

la génération du bit majeur dans l'entête de synchronisation ;

l'inversion du bit majeur afin d'obtenir le bit mineur dans l'entête de synchronisation.

**4.** Procédé de codage et de transmission de données selon l'une quelconque des revendications 1 à 3, le procédé comprenant en outre, avant d'exécuter le codage FEC :

l'embrouillage des données d'informations.

**5.** Procédé de codage et de transmission de données selon l'une quelconque des revendications 1 à 4, le procédé comprenant en outre, si la longueur totale des données d'informations et des bits majeurs est inférieure à la longueur requise pour le codage FEC :

l'ajout de bits de remplissage prédéterminés à la séquence comprenant les données d'informations et les bits majeurs avant d'exécuter le codage FEC, la longueur totale des données d'informations, des bits majeurs et des bits de remplissage prédéterminés ajoutés étant égale à la longueur requise pour le codage FEC, et les données d'informations, les bits majeurs et les bits de remplissage prédéterminés ajoutés étant utilisés pour le codage FEC afin de générer les blocs de vérification ; et

après l'exécution du codage FEC, l'élimination des bits de remplissage prédéterminés ajoutés du résultat du codage FEC.

**6.** Procédé de réception et de décodage de données, lesdites données comprenant des blocs d'informations et des blocs de vérification,
chaque bloc d'informations comprenant un entête de bloc et des données d'informations, l'entête de bloc étant un entête de synchronisation comprenant un bit majeur et un bit mineur, le bit majeur de l'entête de synchronisation étant utilisé pour la synchronisation des blocs et indiquant le type des données d'informations du bloc, et le bit mineur de l'entête de synchronisation étant utilisé pour la synchronisation des blocs ;
le procédé comprenant :

la réception des blocs d'informations et des blocs de vérification ;
l'exécution d'un décodage de Correction d'Erreurs sans Voie de Retour, FEC, sur les données d'informations et le bit majeur dans l'entête de bloc de chaque bloc d'informations reçu avec les blocs de vérification, le bit mineur contenu dans l'entête de bloc de chaque bloc d'informations n'intervenant pas dans le décodage FEC.

**7.** Procédé de réception et de décodage de données selon la revendication 6, le procédé comprenant en outre, après l'exécution du décodage FEC :

l'exécution d'un décodage de ligne sur un bloc d'informations comprenant le bit mineur, les données d'informations et le bit majeur après le décodage FEC ;
le type des données d'informations étant déterminé conformément au bit majeur pendant le décodage de ligne et le bit mineur intervenant dans le décodage de ligne étant obtenu par réception ou par inversion du bit majeur obtenu par décodage FEC.

**8.** Procédé de réception et de décodage de données selon la revendication 6, le procédé comprenant en outre, après l'exécution du décodage FEC :

l'exécution d'un décodage de ligne sur les données d'informations et le bit majeur après le décodage FEC ;
le type des données d'informations étant déterminé conformément au bit majeur pendant le décodage de ligne.

**9.** Procédé de réception et de décodage de données selon l'une quelconque des revendications 6 à 8, le procédé comprenant en outre, après l'exécution du décodage FEC :

le désembrouillage des données d'informations.

**10.** Procédé de réception et de décodage de données selon l'une quelconque des revendications 6 à 9, le procédé comprenant en outre, si la longueur totale des données d'informations et des bits majeurs est inférieure à la longueur requise pour le décodage FEC :

l'ajout de bits de remplissage prédéterminés à la séquence comprenant les données d'informations et les bits majeurs avant d'exécuter le décodage FEC, la longueur totale des données d'informations, des bits majeurs et des bits de remplissage prédéterminés ajoutés étant égale à la longueur requise pour le décodage FEC, et les données d'informations, les bits majeurs et les bits de remplissage prédéterminés ajoutés étant utilisés pour le décodage FEC avec les blocs de vérification ; et
après l'exécution du décodage FEC, l'élimination des bits de remplissage prédéterminés ajoutés du résultat du décodage FEC.

**11.** Appareil de codage et de transmission de données, comprenant :

un module de codage de Correction d'Erreurs sans Voie de Retour, FEC, configuré pour exécuter un codage FEC sur des données d'informations et un bit majeur dans un entête de bloc de blocs d'informations, un bit mineur dans l'entête de bloc des blocs d'informations n'intervenant pas dans le codage FEC, et générer des blocs de vérification par ledit codage FEC ; et
un module d'envoi, configuré pour envoyer les blocs d'informations et les blocs de vérification ;
chaque bloc d'informations comprenant l'entête de bloc et les données d'informations, l'entête de bloc étant un entête de synchronisation comprenant le bit majeur et le bit mineur, le bit majeur de l'entête de synchronisation étant utilisé pour la synchronisation des blocs et indiquant le type des données d'informations du bloc, et le bit mineur de l'entête de synchronisation étant utilisé pour la synchronisation des  blocs.

**12.** Appareil de codage et de transmission de données selon la revendication 11, l'appareil comprenant en outre :

un premier module de codage de ligne, configuré pour exécuter un codage de ligne sur les données d'informations afin de générer le bit majeur et le bit mineur dans l'entête de synchronisation, pour fournir en sortie les données d'informations et le bit majeur au module de codage FEC, et pour fournir en sortie le bit mineur avec le résultat du module de codage FEC au module d'envoi.

**13.** Appareil de codage et de transmission de données selon la revendication 11, l'appareil comprenant en outre :

un second module de codage de ligne, configuré pour exécuter un codage de ligne sur les données d'informations afin de générer le bit majeur, et pour fournir en sortie les données d'informations et le bit majeur au module de codage FEC ;
un module d'inversion, configuré pour inverser les bits majeurs fournis en sortie par le second module de codage de ligne, et pour fournir en sortie le résultat de l'inversion avec le résultat de traitement du module de codage FEC au module d'envoi.

**14.** Appareil de codage et de transmission de données selon la revendication 11 ou 13, l'appareil comprenant en outre :

un module d'embrouillage, configuré pour embrouiller les données d'informations ;
le résultat de l'embrouillage étant fourni en sortie au premier module de codage de ligne ou au second module de codage de ligne, ou le module d'embrouillage embrouillant les données d'informations fournies en sortie par le premier module de codage de ligne ou par le second module de codage de ligne, puis fournissant en sortie le résultat de l'embrouillage au module de codage FEC.

**15.** Appareil de codage et de transmission de données selon l'une quelconque des revendications 11 à 14, l'appareil comprenant en outre, si la longueur totale des données d'informations et des bits majeurs est inférieure à la longueur requise pour le codage FEC :

un module de remplissage, configuré pour mettre en tampon la séquence comprenant les données d'informations et les bits majeurs, et insérer des bits de remplissage prédéterminés à une position prédéterminée de la séquence, puis fournir en sortie les données d'informations, les bits majeurs et les bits de remplissage prédéterminés insérés au module de codage FEC, la longueur totale des données d'informations, des bits majeurs et des bits de remplissage prédéterminés insérés étant égale à la longueur requise pour le codage FEC ;
un filtre, configuré pour éliminer les bits de remplissage prédéterminés insérés du résultat de codage fourni en sortie par le module de codage FEC, puis pour fournir en sortie au module d'envoi.

**16.** Appareil de réception et de décodage de données, comprenant :

un module de réception, configuré pour recevoir des blocs d'informations et des blocs de vérification ; et
un module de décodage de Correction d'Erreurs sans Voie de Retour, FEC, configuré pour exécuter un décodage FEC sur des données d'informations et un bit majeur dans un entête de bloc du bloc d'informations reçu avec les blocs de vérification, un bit mineur contenu dans l'entête de bloc des blocs d'informations n'intervenant pas dans le décodage FEC ;
chaque bloc d'informations comprenant l'entête de bloc et les données d'informations,
l'entête de bloc étant un entête de synchronisation comprenant le bit majeur et le bit mineur, le bit majeur de l'entête de synchronisation étant utilisé pour la synchronisation des blocs et indiquant le type des données d'informations du bloc, et
le bit mineur de l'entête de synchronisation étant utilisé pour la synchronisation des blocs.

**17.** Appareil de réception et de décodage de données selon la revendication 16, l'appareil comprenant en outre :

un premier module de décodage de ligne, configuré pour exécuter un décodage de ligne sur les blocs d'informations comprenant le bit mineur, les données d'informations et le bit majeur après le décodage FEC, le type des données d'informations étant déterminé conformément au bit majeur pendant le décodage de ligne et le bit mineur intervenant dans le décodage de ligne étant fourni en sortie par le module de réception ou étant obtenu par inversion du bit majeur des blocs d'informations fournis en sortie par le module de décodage FEC.

**18.** Appareil de réception et de décodage de données selon la revendication 16, l'appareil comprenant en outre :

un second module de décodage de ligne, configuré pour exécuter un décodage de ligne sur les données d'informations et le bit majeur des blocs d'informations après le décodage FEC, le type des données d'informations étant déterminé conformément au bit majeur pendant le décodage de ligne.

**19.** Appareil de réception et de décodage de données selon l'une quelconque des revendications 16 à 18, l'appareil comprenant en outre :

un module de désembrouillage, configuré pour désembrouiller les données d'informations;
le module de désembrouillage désembrouillant les données d'informations fournies en sortie par le premier module de décodage de ligne ou par le second module de décodage de ligne, ou le module de désembrouillage désembrouillant les données d'informations fournies en sortie par le module de décodage FEC, puis fournissant en sortie le résultat de désembrouillage au premier module de décodage de ligne ou au second module de décodage de ligne.

**20.** Appareil de réception et de décodage de données selon l'une quelconque des revendications 16 à 19, l'appareil comprenant en outre, si la longueur totale des données d'informations et des bits majeurs est inférieure à la longueur requise pour le décodage FEC :

un module de remplissage, configuré pour mettre en tampon la séquence comprenant les données d'informations et les bits majeurs, et insérer des bits de remplissage prédéterminés à une position prédéterminée de la séquence, puis pour fournir les données d'informations, les bits majeurs et les bits de remplissage prédéterminés insérés au module de décodage FEC, la longueur totale des données d'informations,
des bits majeurs et des bits de remplissage prédéterminés ajoutés étant égale à la longueur requise pour le décodage FEC ; et
un filtre, configuré pour éliminer les bits de remplissage prédéterminés insérés du résultat de décodage fourni en sortie par le module de décodage FEC.

FIG. 1

Reconciliation sublayer

XGMII

Physical coding sublayer

64b/66b line decoding

Descrambler

FEC decoding

Synchronization

PMA sublayer

PMD sublayer

FIG. 2

64b/66b line encoding

Minor bit

Major bit

D64

⋮

D1

Buffer

FEC encoding

Cn

⋮

C1

FIG. 3

Reconciliation sublayer

XGMII

PCS

64-bit data information is generated  410

1 2 3 ... 64

The 64-bit data information is scrambled  420

Sync header

1 2 3 ... 64

64b/66b line encoding  430

440'

1 2 3 ... 64

Sync header buffering/ sorting

Codeword buffering/ sorting  440

FEC encoding  450

The framing module performs reassembling and framing  460

PMA

FIG. 4

EP 2 101 415 B1

Scrambled
information block

| 1 | S1 | 64 | 1 | S2 | 64 | ... | 1 | Sk | 64 |

64b/66b line
encoding

Syne header

Information block after
line encoding

| | 1 | S1 | 64 | | 1 | S2 | 64 | ... | | 1 | Sk | 64 |

FEC input information
buffering/sorting

| | 1 | S1 | 64 | | 1 | S2 | 64 | ... | | 1 | Sk | 64 | FEC coding |

Check word
buffering/sorting

| | 1 | S1 | 64 | | 1 | S2 | 64 | ... | | 1 | Sk | 64 | 1 | P1 | 64 | ... | 1 | Pm | 64 |

Check word sync
header module

Check word sync header

FEC codewrd with
sync headers

| | 1 | S1 | 64 | | 1 | S2 | 64 | ... | | 1 | Sk | 64 | | 1 | P1 | 64 | ... | | 1 | Pm | 64 |

Framing module → Rate adjuster → PMA

FIG 5

XGMII

FIG. 6

Information after
line decoding

FEC decoding
output

FEC
codeword

Received
data

PMA

FIG. 7

Scrambled information block

| 1 | S1 | 64 | 1 | S2 | 64 | ... | 1 | Sk | 64 |

64 b / 66 b line encoding

Sync header

Information after line encoding

| | 1 | S1 | 64 | | 1 | S2 | 64 | ... | | 1 | Sk | 64 |

FEC input information buffering/sorting, and zero filling

| 0 | 1 | S1 | 64 | 0 | 1 | S2 | 64 | ... | 0 | 1 | Sk | 64 |

FEC coding

Check word buffering/sorting

| 0 | 1 | S1 | 64 | 0 | 1 | S2 | 64 | ... | 0 | 1 | Sk | 64 | 1 | P1 | 64 | ... | 1 | PM | 64 |

Shortened code filter

| 1 | S1 | 64 | 1 | S2 | 64 | ... | 1 | Sk | 64 | 1 | P1 | 64 | ... | 1 | PM | 64 |

Check word sync header module

Check word sync header

| 1 | S1 | 64 | 1 | S2 | 64 | ... | 1 | Sk | 64 | 1 | 1 | P1 | 64 | ... | 1 | 1 | PM | 64 |

Sync header buffering

FEC codeword with sync headers

| 1 | S1 | 64 | 1 | S2 | 64 | ... | 1 | Sk | 64 | 1 | 1 | P1 | 64 | ... | 1 | 1 | PM | 64 |

Framing module → Rate adjuster → PMA

FIG 8

FIG. 9

FIG. 10

FIG. 11

FIG. 12

FIG. 13

30

FEC input information
buffer/sorter

Check word buffer/sorter

Scrambled
64-bit
information
block

64b/66b line
encoder

1 ... 65

FEC
encoder

...

66

Sync
header
buffer/
sorter

Framing
module,
Code
rate
adjuster

PMA

FIG. 14

FEC input information
buffer/sorter

Check word buffer/sorter

Scrambled
64-bit
information
block

64b/66b line
encoder

1 ... 65

FEC
encoder

...

65

Not-
gate

Sync
header
buffer/
sorter

...

FEC output information
buffer/sorter

Framing
module,
Rate
adjuster

PMA

FIG. 15

FEC input information
buffer/sorter

Check word buffer/sorter

Scrambled
64-bit
information
block

64b/66b line
encoder

1 ... 65

FEC
encoder

65

Not-
gate

Framing
module,
Rate
adjuster

PMA

Sync
header
buffer/
sorter

FIG. 16

Receiving
module
(synchroni
zer)

FEC decoding

64b/66b line
decoding

Descrambling
module

FIG. 17

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006098686 A1

- US 2005028066 A1